# EUROPÄISCHE PATENTSCHRIFT

(11) **EP 2 745 656 B1**
(45) Veröffentlichungstag und Bekanntmachung des Hinweises auf die Patenterteilung: **05.09.2018**
(21) Anmeldenummer: 12732572.8
(22) Anmeldetag: 18.06.2012
(51) Int. Cl.: H05K 3/04

(54) **VERFAHREN ZUM METALLISIEREN VON POLYMERSCHICHTSYSTEMEN UND POLYMERSCHICHTSYSTEME**
METHOD FOR METALLIZING POLYMER LAYER SYSTEMS, AND POLYMER LAYER SYSTEMS
PROCÉDÉ DE MÉTALLISATION DE SYSTÈMES DE COUCHES POLYMÈRES ET SYSTÈMES DE COUCHES POLYMÈRES

(30) Priorität: 15.08.2011 DE 102011080934
(43) Veröffentlichungstag der Anmeldung: 25.06.2014
(73) Patentinhaber: Robert Bosch GmbH, 70442 Stuttgart (DE)
(72) Erfinder: DAUB, Martina, 71287 Weissach (DE); BRETTSCHNEIDER, Thomas, 70806 Kornwestheim (DE); DORRER, Christian, 70193 Stuttgart (DE)
(86) Internationale Anmeldenummer: PCT/EP2012/061544
(87) Internationale Veröffentlichungsnummer: WO 2013/023812

(56) Entgegenhaltungen:
- DE-A1- 10 347 035
- DE-B4- 10 125 570
- US-A- 5 062 939
- US-A1- 2006 234 163

## Beschreibung

Die Erfindung betrifft Verfahren zum Metallisieren von Polymerschichtsystemen und entsprechende Polymerschichtsysteme.

### Stand der Technik

Integrierte mikrofluidische Bauteile, z.B. Lab-on-a-Chip-Systeme in der Medizintechnik, bestehen häufig aus einem polymeren Mehrschichtaufbau mit eingeschlossenen mikrofluidischen Strukturen, wie z.B. Kanälen und Kammern.

Neben optischen Sensorsystemen als Schnittstelle zur Außenwelt gibt es vermehrt Bestrebungen, auf dem Chip integrierte elektrische Detektionssysteme zu etablieren. Dies erfordert eine Integration elektrischer Leiterbahnen und Kontaktierungsmöglichkeiten im Polymerschichtsystem. Weiterhin lassen sich mit Metallisierungsprozessen für Polymerschichtsysteme u.a. auch Elektroden an den Kanalwänden realisieren, um Messungen am betreffenden Fluid durchzuführen.

Für die Metallisierung von Polymeren gibt es eine Reihe von Verfahren, wie z.B. Sputtern, lithographische Verfahren, Laserablation, Lasersintern, Molded Interconnect Devices (3D-MID), Siebdruck mit leitfähigen Pasten, Inkjet-Verfahren usw.

Die JP-2004232045 A offenbart ein Sputter-Verfahren zum Sputtern von Metallfilmen auf ein Polymer.

Aus Sensors and Actuators A 134 (2007), Seiten 161 bis 168 ist eine Inkjet-Technik mit leitfähiger Tinte für die Metallisierung von Polymeren bekannt.

Die DE 10 2008 040 882 A1 beschreibt ein Verfahren zum Heißprägen von Leiterbahnen auf Polymersubstrate. Dabei erfolgt der Prägevorgang mit einer auf dem Polymersubstrat ausgelegten Metallfolie, die einseitig für eine verbesserte Haftung des Polymers mit aufgewachsenen Dendriten versehen ist. Beim Prägevorgang wird eine Haftung zwischen dem Polymer und der Metallfolie erreicht und gleichzeitig die Metallfolie an vorgegebenen Stellen getrennt, um eine elektrisch isolierte Leiterbahnen zu erzeugen.

Die DE 103 50 568 A1 offenbart ein Verfahren zur Herstellung von Folienkabeln und Leiterbahnträgern für gedruckte Schaltungen, wobei eine thermoplastische Kunststoffträgerfolie oder thermoplastische Leiterplatte oder ein thermoplastischer Multilayer mit Leiterbahnen durch Laserstrahlung mit einer thermoplastischen Deckfolie verschweißt wird.

Die DE 101 25 570 A1 offenbart ein Verfahren, wobei Oberflächen von Kunststoffen unter Zuhilfenahme von Laserstrahlen mit elektrischen Leiterbahnen versehen werden. Aus den Dokumenten DE 10347035 A1, US 5062939 A und US 2006/234163 A1 sind Verfahren zum Metallisieren von Polymerschichtsystemen bekannt.

### Offenbarung der Erfindung

Die Erfindung schafft Verfahren zum Metallisieren von Polymerschichtsystemen nach Anspruch 1 bzw. 8 und Polymerschichtsysteme nach Anspruch 10 12 bzw. 13 Bevorzugte Weiterbildungen sind Gegenstand der jeweiligen Unteransprüche.

### Vorteile der Erfindung

Die vorliegende Erfindung ermöglicht es, Metallstrukturbereiche durch einen einfachen Laserschweißprozess in ein Polymerschichtsystem mit einem Polymersubstrat und einer Polymermembran zu integrieren. Entsprechend strukturiert können die Metallstrukturbereiche beispielsweise als Leiterbahnen, Elektroden, Heizstrukturen und Kontaktflächen beispielsweise zur Flip-Chip-Kontaktierung eines elektrischen Bauteils dienen.

Bei einer bevorzugten Ausführungsform lässt sich durch Laserdurchstrahlschweißen in einem einzigen Schritt eine Verbindung zwischen der Metallfolie und der Polymermembran sowie der Polymermembran und dem Polymersubstrat erstellen. An der Grenzschicht zwischen Polymermembran und Polymersubstrat wird eine Fügung nach dem Laserschweißprinzip, d.h. Erhitzung über die Glasübergangstemperatur und Vermischung der beiden Materialien, erreicht. An der Grenzschicht zwischen Metallfolie und Polymermembran kann zwar keine Durchmischung stattfinden, dennoch erhält man eine Haftung (Adhäsion).

Es ergibt sich ein großer Vorteil bezüglich Kosten und Aufwand gegenüber dem bisher bekannten Stand der Technik.

Insbesondere ist es möglich, unbeschichtete Metallfolien zu benutzen, z.B. handelsübliche Aluminiumfolien. Es sind keine speziellen Zusatzmaterialien nötig, wie z.B. leitfähige Tinte beim Inkjet-Verfahren bzw. Paste beim Siebdruckverfahren. Durch die Möglichkeit der Strukturierung per Laser sind keine an das Leiterbahndesign gebundenen Masken oder Werkzeuge nötig, wie das bei Lithographie, Sputtern bzw. Heißprägen der Fall ist.

Da die Polymerschichten bereits mit dem Laserdurchstrahlschweißen gefügt werden können, ist die Herstellung einer strukturierten Metallisierung mit wenigen zusätzlichen Schritten möglich.

Der Prozess ist mehrlagenfähig, d.h. Schichten aus Polymermembran und strukturierter Metallfolie können sich abwechseln. Es gibt keine nennenswerten Einschränkungen bezüglich der realisierbaren Geometrie der Strukturierung. Im Falle des oben genannten Heißprägens von Leiterbahnen sind beispielsweise Krümmungen von Leiterbahnen problematisch, was bei der vorliegenden Erfindung nicht der Fall ist.

Die Dicke der Metallfolie lässt sich über einen weiten Bereich an die entsprechende Anwendung anpassen.

Durch entsprechend metallisierte Flächen können biochemische Reaktionen, beispielsweise in einem Lab-on-a-Chip, lokal beeinflusst werden, z.B. durch das Fließen eines Stroms oder das Wirken als Katalysator.

Allgemein haben die erfindungsgemäßen Systeme den weiteren Vorteil, dass durch die Verbindung der Metallfolie über die Polymermembran mit dem Polymersubstrat automatisch eine Stressentkopplung der Leiterbahnen aufgrund der Flexibilität der Polymermembran gewährleistet werden kann. So kann sichergestellt werden, dass elektrische Kontakte bzw. Leiterbahnen o.ä. auch beim Durchlaufen von Temperaturzyklen unbeschädigt bleiben.

Im Gegensatz zum Gegenstand der DE 101 25 570 A1 kann eine laserbasierte Strukturierung der Metallfolie nach dem Verbinden mit der Polymeroberfläche erfolgen. Hierdurch entfällt das Problem der Ausrichtung einer vorher strukturierten Metallfolie bzgl. der darunterliegenden Oberfläche. Dadurch ist es möglich, beispielsweise Leiterbahnen an im Polymer vorhanden Kanälen und Kavitäten sehr genau auszurichten.

### Kurze Beschreibung der Zeichnungen

Weitere Merkmale und Vorteile der vorliegenden Erfindung werden nachfolgend anhand von Ausführungsformen mit Bezug auf die Figuren erläutert.

Es zeigen:
- Fig. 1a)-d): schematische Ansichten zur Erläuterung eines Verfahrens zum Metallisieren von Polymerschichtsystemen gemäß einer ersten Ausführungsform der vorliegenden Erfindung, und zwar Fig. 1a) und b) im Querschnitt und Fig. 1c) und d) in Aufsicht auf den metallisierten Bereich;
- Fig. 2a)-c): schematische Ansichten zur Erläuterung eines Verfahrens zum Metallisieren von Polymerschichtsystemen gemäß einer zweiten Ausführungsform der vorliegenden Erfindung, und zwar Fig. 2a) und b) im Querschnitt und Fig. 2c) in Aufsicht auf den metallisierten Bereich;
- Fig. 3: eine schematische Querschnittsansicht zur Erläuterung eines Verfahrens zum Metallisieren von Polymerschichtsystemen gemäß einer dritten Ausführungsform der vorliegenden Erfindung;
- Fig. 4: eine schematische Querschnittsansicht zur Erläuterung eines Verfahrens zum Metallisieren von Polymerschichtsystemen gemäß einer vierten Ausführungsform der vorliegenden Erfindung;
- Fig. 5: eine schematische Querschnittsansicht zur Erläuterung eines Polymerschichtsystems gemäß einer fünften Ausführungsform der vorliegenden Erfindung;
- Fig. 6: eine schematische Querschnittsansicht zur Erläuterung eines Polymerschichtsystems gemäß einer sechsten Ausführungsform der vorliegenden Erfindung;
- Fig. 7: eine schematische Querschnittsansicht zur Erläuterung eines Polymerschichtsystems gemäß einer siebenten Ausführungsform der vorliegenden Erfindung;
- Fig. 8a)-d): schematische Querschnittsansichten zur Erläuterung eines Polymerschichtsystems gemäß einer achten Ausführungsform der vorliegenden Erfindung; und
- Fig. 9a)-c): schematische Querschnittsansichten zur Erläuterung eines Polymerschichtsystems gemäß einer neunten Ausführungsform der vorliegenden Erfindung.

### Ausführungsformen der Erfindung

In den Figuren bezeichnen gleiche Bezugszeichen gleiche bzw. funktionsgleiche Elemente.

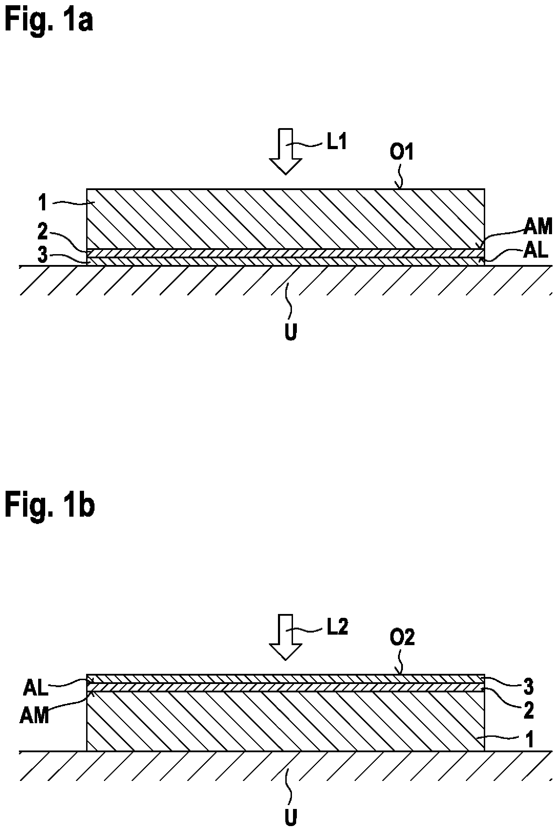

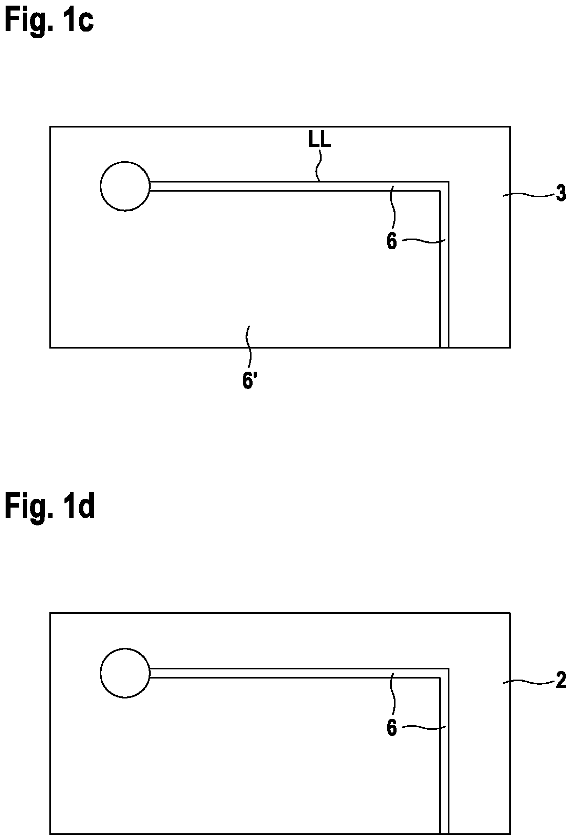

Fig. 1a)-d) sind schematische Ansichten zur Erläuterung eines Verfahrens zum Metallisieren von Polymerschichtsystemen gemäß einer ersten Ausführungsform der vorliegenden Erfindung, und zwar Fig. 1a) und b) im Querschnitt und Fig. 1c) und d) in Aufsicht auf den metallisierten Bereich.

In Fig. 1a) bezeichnet Bezugszeichen 1 ein transparentes Polymersubstrat, 2 eine lichtabsorbierende Polymermembran und 3 eine Metallfolie.

Aus dem Polymersubstrat 1, der Polymermembran 2 und der Metallfolie 3 ist ein Schichtstapel auf einer Unterlage U gebildet. Die Grenzfläche zwischen der Metallfolie 3 und der Polymermembran 2 ist mit Bezugszeichen AL gekennzeichnet, wohingegen die Grenzfläche zwischen Polymermembran 2 und Polymersubstrat 1 mit Bezugszeichen AM gekennzeichnet ist. Bezugszeichen O1 bezeichnet die der Polymermembran 2 abgewandte Oberfläche des Polymersubstrats 1.

Als Polymersubstrat 1 lassen sich beispielsweise Thermoplaste, wie z.B. PC, PP, PE, PMMA, COP, COC usw. verwenden. Als Polymermembran eignen sich thermoplastische Elastomere sowie Thermoplaste. Als Metallfolie eignen sich u.a. Aluminiumfolie, Kupferfolie, Goldfolie, Silberfolie usw.

Beispielhafte Abmessungen im Schichtstapel sind eine Dicke des Polymersubstrats 1 zwischen 0,5 und 3 mm, eine Dicke der Polymermembran 2 zwischen 25 und 300 µm und eine Dicke der Metallfolie 3 zwischen 5 und 500 µm. Die Breite der Leiterbahn 6 beträgt typischerweise 20 µm bis 5 mm. Die laterale Abmessung der Struktur gemäß Fig. 1a) beträgt beispielsweise 10 x 10 bis 100 x 100 mm².

Im Prozesszustand gemäß Fig. 1a) erfolgt ein Laserbestrahlungsschritt L1 durch die von der Polymermembran 2 abgewandte Oberfläche O1 des Polymersubstrats 1, wodurch eine Schweißverbindung zwischen dem Polymersubstrat 1 und der Polymermembran 2 entsteht. Während des Laserbestrahlungsschritts L1 werden die Polymermembran 2 und das angrenzende Polymersubstrat 1 verflüssigt, und durch die Vermischung und Interdiffusion der Makromoleküle entsteht eine Schweißverbindung bzw. Fügeverbindung. Gleichzeitig wird bei diesem Laserbestrahlungsschritt L1 in Kombination mit einem vorgegebenen Anpressdruck eine Haftung (Adhäsion) zwischen der Metallfolie 3 und der Polymermembran 2 erreicht.

Um die Adhäsion zwischen der Metallfolie 3 und der Polymermembran 2 zu erhöhen, kann vor der Bildung des Schichtstapels 1, 2, 3 eine Plasmareinigung bzw. -aktivierung der Oberflächen von Polymermembran 2 und Metallfolie 3 an der Grenzfläche AL durchgeführt werden. Alternativ oder zusätzlich kann ein Aufrauen der Metallfolie 3 an der Grenzfläche AL durchgeführt werden, beispielsweise mit einer entsprechenden Laserbehandlung.

Eine verbesserte Haftung (Adhäsion) kann ebenfalls durch Verwendung von Metallfolien erreicht werden, die speziell beschichtet wurden, z.B. mit Siegellack, Klebstoff (beispielsweise Resin-Coated Copper RCC) oder mit aufgewachsenen dendritischen Strukturen (Elektroplattierung) bzw. Schwarzoxid-Beschichtung.

Weiter mit Bezug auf Fig. 1b) wird der Schichtstapel 1, 2, 3 in verbundenem Zustand nach dem Laserbestrahlungsschritt L1 auf der Unterlage U umgedreht und ein weiterer Laserbehandlungsschritt L2 auf der der Polymermembran 2 abgewandten Oberfläche O2 der Metallfolie 3 durchgeführt. In einer alternativen Ausführungsform kann der Laserbehandlungsschritt L2 auch durch einen weiteren Laser von der Unterseite erfolgen, ohne dass ein Umdrehen erforderlich ist.

Beim Laserbehandlungsschritt L2 werden ein oder mehrere Strukturbereiche 6 in der Metallfolie 3 gebildet, beispielsweise Leiterbahnen. Dabei umfährt der Laserstrahl den Strukturbereich 6 und bildet an seinem Rand eine entsprechende Schnittlinie LL in der Metallfolie 3, entlang derer die Metallfolie 3 durchgetrennt ist. Der Zustand nach Beendigung des Laserbehandlungsschritts L2 ist in Fig. 1c) dargestellt.

Weiter mit Bezug auf Fig. 1d) lässt sich der zu dem Strukturbereich 6 in Form der Leiterbahn komplementäre Bereich 6' der Metallfolie nach Beendigung des Laserbehandlungsschritts L2 abziehen und somit entfernen. Damit die Polymermembran 2 beim Abziehen unbeschädigt bleibt, muss die Adhäsionskraft der vollflächigen Verbindung entlang der Grenzfläche AL bei der Stapelbildung entsprechend gewählt werden.

Der Endzustand mit dem Strukturbereich 6 in Form der Leiterbahn auf der Polymermembran 2 nach Entfernen des komplementären Bereichs 6' ist in Fig. 1d) gezeigt.

Bei einer alternativen Ausführungsform kann während des Laserbehandlungsschritts L1 auch nur der Strukturbereich 6 erhitzt werden, welcher nach dem Laserbehandlungsschritt L2 metallisiert zurückbleiben soll. Auf diese Weise löst sich der komplementäre Bereich 6' nach dem Schritt L2 sofort von der Oberfläche und es ist kein zusätzlicher Schritt notwendig, um die überschüssige Metallfolie 3 abzuziehen. Bei diesem Vorgehen ist es möglich, dass beim Schritt L2 auch die Polymermembran 2 durchtrennt wird und sich die Polymermembran 2 zusammen mit Metallfolie 3 im komplementären Bereich 6' ablöst. Um dies zu verhindern (die Polymermembran kann weitere Funktionen erfüllen), kann zunächst ein Schichtaufbau bestehend aus Polymersubstrat 1 und Polymermembran 2 mit Laserdurchstrahlschweißen auf allen Bereichen des Polymersubstrats 1 verbunden werden und anschließend der Metallisierungsvorgang durchgeführt werden, indem die Metallfolie 3 auf die Polymermembran 2 aufgelegt wird und nur der Strukturbereich 6 im Laserbehandlungsschritt L1 erhitzt wird.

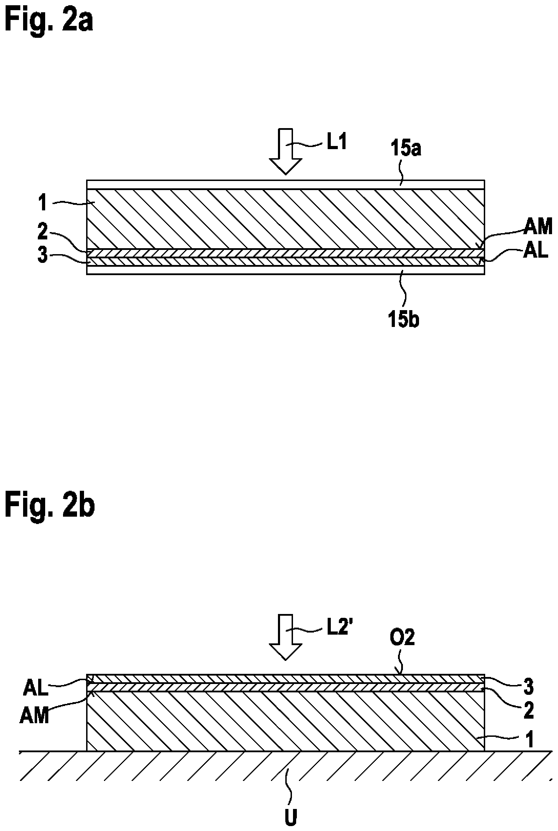

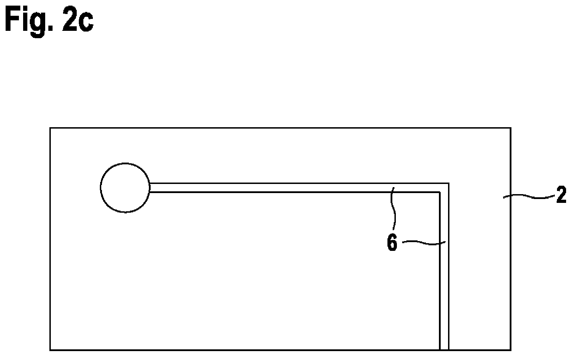

Fig. 2a)-c) sind schematische Ansichten zur Erläuterung eines Verfahrens zum Metallisieren von Polymerschichtsystemen gemäß einer zweiten Ausführungsform der vorliegenden Erfindung, und zwar Fig. 2a) und b) im Querschnitt und Fig. 2c) in Aufsicht auf den metallisierten Bereich.

Wie in Fig. 2a) dargestellt, ist bei der zweiten Ausführungsform eine transparente Einspanneinrichtung 15a, 15b, beispielsweise in Form zweier entsprechender transparenter Platten, vorgesehen, um den Schichtstapel 1, 2, 3 während des Laserbehandlungsschritts L1 einzuspannen und damit die Adhäsion bzw. die Schweißverbindung stabiler zu gestalten.

Gemäß Fig. 2b) wird der Laserbehandlungsschritt L2' bei der zweiten Ausführungsform anders als bei der ersten Ausführungsform durchgeführt. Insbesondere erfolgt bei der zweiten Ausführungsform im Laserbehandlungsschritt L2' eine Laserablation des komplementären Bereich 6', was schließlich zum in Fig. 2c) gezeigten Zustand führt.

Die Haftung des Strukturbereichs 6 in Form der Leiterbahn kann wie bei der ersten Ausführungsform durch Verwendung unterschiedlicher Bestrahlungsintensitäten bzw. Bestrahlungsraster bedarfsgerecht eingestellt werden.

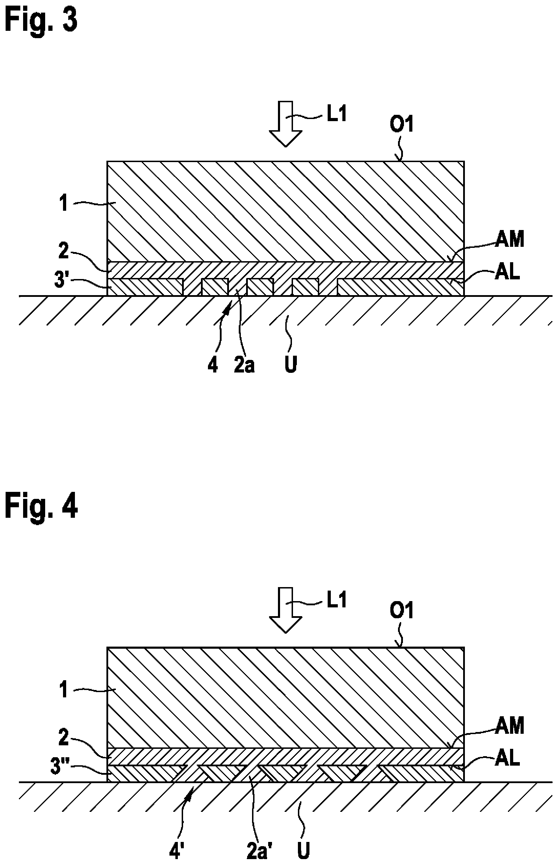

Fig. 3 ist eine schematische Querschnittsansicht zur Erläuterung eines Verfahrens zum Metallisieren von Polymerschichtsystemen gemäß einer dritten Ausführungsform der vorliegenden Erfindung.

Bei der dritten Ausführungsform gemäß Fig. 3 ist der Zustand unmittelbar nach dem Laserbehandlungsschritt L1 zum Erstellen der Schweißverbindung zwischen Polymersubstrat 1 und Polymermembran 2 dargestellt.

Bei dieser dritten Ausführungsform wurde die Metallfolie 3' vor der Bildung des Schichtstapels 1, 2, 3' erfindungsgemäß mit Perforationen 4, beispielsweise Löchern, versehen. Derartige Perforationen 4 können entweder vollflächig vorgesehen werden oder nur in gewissen Bereichen, wo später eine erhöhte Haftung gewünscht ist, beispielsweise nur in den Leiterbahnbereichen.

Die Durchmesser der löchrigen Strukturen mit den Perforationen 4 in der Metallfolie 3' betragen beispielsweise 5 bis 200 µm.

Während des Laserbehandlungsschritts L1 verflüssigt sich die Polymermembran 2 und breitet sich durch die Perforationen 4 in Form von Stegen 2a aus. Nach dem Abkühlen sorgen diese Stege 2a für eine verstärkte Verbindung zwischen der Metallfolie 3' und der Polymermembran 2.

Beispielsweise lassen sich die Perforationen 4 gemäß Fig. 3 durch einen entsprechenden Stanzvorgang in die Metallfolie 3' einbringen.

Fig. 4 ist eine schematische Querschnittsansicht zur Erläuterung eines Verfahrens zum Metallisieren von Polymerschichtsystemen gemäß einer vierten Ausführungsform der vorliegenden Erfindung.

Bei der vierten Ausführungsform gemäß Fig. 4 sind die Perforationen mit Bezugszeichen 4' und die Stege mit Bezugszeichen 2a' bezeichnet und wurden mittels eines Lasers in die Metallfolie 3" eingebracht. Durch diese Art der Laserperforation der Metallfolie 3" von der der Polymermembran 2 abgewandten Seite ergeben sich kraterförmige bzw. kegelförmige Perforationen 4', welche sich zu der von der Polymermembran 2 abgewandten Seite hin aufweiten, wodurch sich eine weiter verbesserte Verbindung zwischen Metallfolie 3" und Polymermembran 2 ergibt.

Die Durchmesser der löchrigen Strukturen mit den Perforationen 4' in der Metallfolie 3" betragen beispielsweise ebenfalls 5 bis 200 µm.

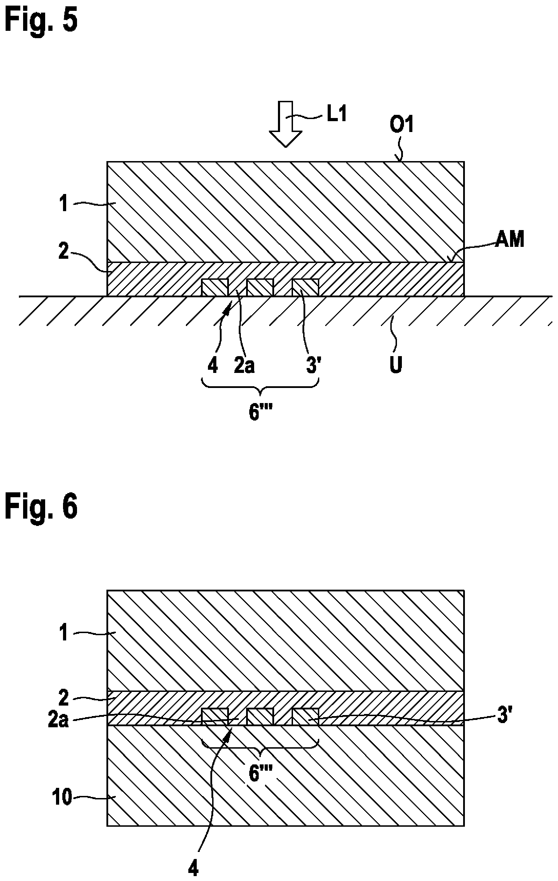

Fig. 5 ist eine schematische Querschnittsansicht zur Erläuterung eines Verfahrens zum Metallisieren von Polymerschichtsystemen gemäß einer fünften Ausführungsform der vorliegenden Erfindung.

Bei der fünften Ausführungsform gemäß Fig. 5 wurde die Metallfolie 3' nach der Durchführung des Laserbehandlungsschritts L1 ausgehend vom Zustand gemäß Fig. 3 zu einer entsprechenden Leiterbahn 6"' strukturiert. Da die Perforationen 4 nur im Bereich der Leiterbahn 6'" vorgesehen sind, ließ sich der komplementäre Bereich 6' nach dem Laserbehandlungsschritt L2 einfach entfernen.

Fig. 6 ist eine schematische Querschnittsansicht zur Erläuterung eines Polymerschichtsystems gemäß einer sechsten Ausführungsform der vorliegenden Erfindung.

Bei der sechsten Ausführungsform ist auf die in Fig. 5 gezeigte fünfte Ausführungsform zusätzlich ein Polymersubstratdeckel 10 auf die Seite mit der strukturierten Leiterbahn 6'" erst aufgebracht und dann verschweißt worden, was beispielsweise durch eine Vorrichtung mit Schweißstempel oder ebenfalls mit Laserdurchstrahlschweißen erreicht werden kann. Duch einen entsprechenden Anpressdruck des Polymersubstratdeckels 10 kann die Leiterbahn 6'" in die Polymermembran 2 eingedrückt werden, so dass bei der Verbindung mit dem Polymersubstratdeckel 10 keine Lufteinschlüsse entstehen. Aufgrund der Perforationen 4 ergibt sich dabei auch im Bereichen der Leiterbahn 6"' eine echte Schweißverbindung, da sich die Polymermembran 2 mit dem Polymersubstratdeckel 10 dort im aufgeschmolzenen Zustand vermischen und verbinden kann.

Ohne Verwendung der Perforationen 4 ergäbe sich eine Fügung nur in Bereichen, wo ein direkter Kontakt zwischen Polymermembran 2 und Polymersubstratdeckel 10 vorliegt.

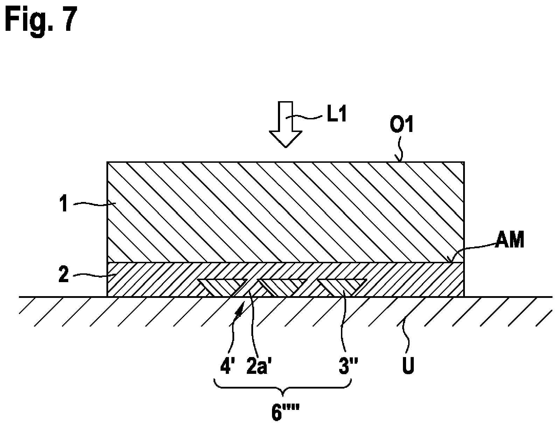

Fig. 7 ist eine schematische Querschnittsansicht zur Erläuterung eines Polymerschichtsystems gemäß einer siebenten Ausführungsform der vorliegenden Erfindung.

Bei der siebenten Ausführungsform gemäß Fig. 7 wurde die Metallfolie 3" nach der Durchführung des Laserbehandlungsschritts L1 ausgehend vom Zustand gemäß Fig. 4 zu einer entsprechenden Leiterbahn 6"" strukturiert. Da die Perforationen 4' nur im Bereich der Leiterbahn 6"" vorgesehen sind, ließ sich der komplementäre Bereich 6' nach dem Laserbehandlungsschritt L2 einfach entfernen.

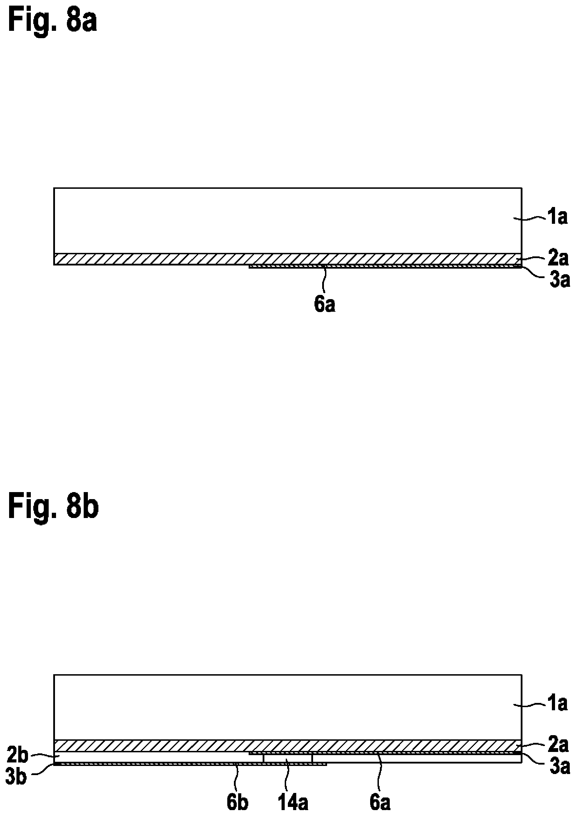

Fig. 8a)-d) sind schematische Querschnittsansichten zur Erläuterung eines Polymerschichtsystems gemäß einer achten Ausführungsform der vorliegenden Erfindung, welche die Realisierung einer Durchkontaktierung bei einem Polymerschichtsystem illustriert.

Gemäß Fig. 8a) wird ein Schichtstapel 1a, 2a, 3a mit einem Polymersubstrat 1a, einer über dem Polymersubstrat 1a angeordneten ersten Polymermembran 2a und einer über der ersten Polymermembran 2a angeordneten ersten Leiterbahn 6a aus einer ersten Metallfolie 3a hergestellt, was beispielsweise mittels des Verfahrens gemäß Fig. 1a) - 1d) erfolgt.

In einem weiteren Prozessschritt, welcher in Fig. 8b) illustriert ist, wird über der ersten Polymermembran 2a und der ersten Leiterbahn 6a eine zweite Polymermembran 2b gebildet und oberhalb der ersten Leiterbahn 6a ein Kontaktloch 14a in der zweiten Polymermembran 2b geschaffen. Anschließend wird eine zweite Leiterbahn 6b aus einer zweiten Metallfolie 3b auf der zweiten Polymermembran 2b und oberhalb des Kontaktlochs 14a erzeugt.

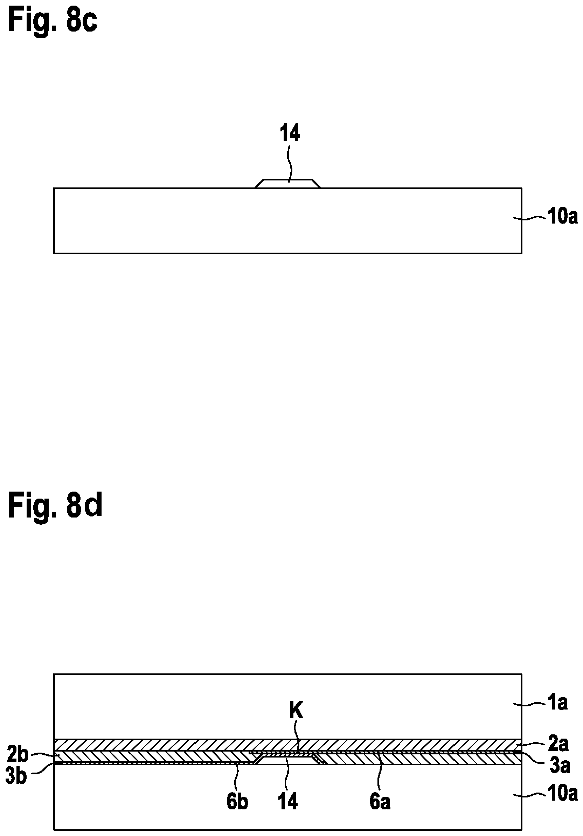

Mit Bezug auf Fig. 8c) wird ein Polymersubstratdeckel 10a bereitgestellt, welcher eine Erhöhung 14 aufweist.

Fügt man den Polymersubstratdeckel 10a mit dem erhöhten Bereich 14 gemäß Fig. 8c) mit der in Fig. 8b) dargestellten Struktur zusammen, so bilden die erste Leiterbahn 6a und die zweite Leiterbahn 6b über dem erhöhten Bereich 14 durch das Kontaktloch 14a einen Kontakt K, wie in Fig. 8d) dargestellt.

Zur weiteren Verbesserung des Kontaktes K können im Bereich des Kontaktes K auf der ersten Leiterbahn 6a elektrisch leitfähige Klebstoffe verwendet werden, die beispielsweise durch Dispensieren oder Siebdruck aufgebracht werden. Ebenso ist es möglich, auf die erste Leiterbahn 6a im Bereich des Kontakts K ein Lot aufzutragen und das Polymerschichtsystem beim Fügen über die Schmelztemperatur des Lots zu erwärmen. Alternativ kann eine direkte Verschweißung der beiden Leiterbahnen 6a, 6b im Bereich des Kontakts K mittels eines Lasers erfolgen.

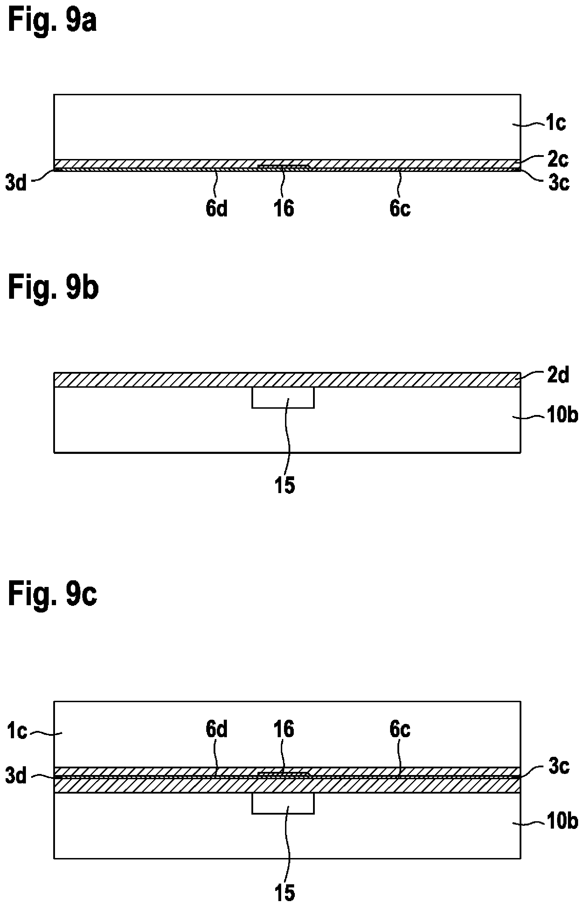

Fig. 9a)-c) sind schematische Querschnittsansichten zur Erläuterung eines Polymerschichtsystems gemäß einer neunten Ausführungsform der vorliegenden Erfindung, welche die Realisierung eines Thermoelements bei einem Polymerschichtsystem illustriert.

Mit Bezug auf Fig. 9a) wird ein Schichtstapel 1c, 2c, 3c, 3d gebildet, welcher ein Polymersubstrat 1c, eine über dem Polymersubstrat 1c angeordnete erste Polymermembran 2c und eine über der ersten Polymermembran 2c angeordnete erste Leiterbahn 6c aus einer ersten Metallfolie 3c sowie eine über der ersten Polymermembran angeordnete zweite Leiterbahn 6d aus einer zweiten Metallfolie aufweist.

Die erste und zweite Leiterbahn 6c, 6d sind im zentralen Bereich des Polymersubstrats 1c überlappend angeordnet und binden dort einen Thermoelementkontakt 16. Die Anordnung gemäß Fig. 9a) lässt sich beispielsweise durch das Verfahren nach einem der Ansprüche 1a) - d) herstellen.

Die Leiterbahnen 6c, 6d bestehen zur Ausbildung einer entsprechenden Thermospannung über dem Thermoelementkontakt 16 aus geeignetem Metallpaaren, wie z. B. NiCr/Ni, FeCu/Ni, Cu/CuNi usw.

Weiterhin wird gemäß Fig. 9b) ein Polymersubstratdeckel 10b bereitgestellt, welcher eine Kavität 15 aufweist. Über dem Polymersubstratdeckel 10b und der Kavität 15 angeordnet ist eine zweite Polymermembran 2d.

Mit Bezug auf Fig. 9c) wird der Polymersubstratdeckel 10b mit der Kavität 15 derart auf dem Schichtstapel angeordnet, dass die Kavität 15 im Bereich des Thermoelementkontakts 16 angeordnet ist. Die Kavität 15 ist beispielsweise Teil eines mikrofluidischen Kanals, in dem die Temperatur bestimmt werden soll.

Oftmals ist die genaue Temperaturbestimmung innerhalb eines Lab-on-a-Chip-Systems von großem Interesse. Hierbei bestand bisher beispielsweise das Problem, dass miniaturisierte Temperatursensoren, wie z.B. Thermoelemente oder Widerstandsthermometer, nur schlecht in die polymere Umgebung integrierbar sind und ein guter thermischer Kontakt durch die Nähe zur entsprechenden Kavität oft mit der Gefahr eines Lecks verbunden sind. Die oben beschriebene neunte Ausführungsform hat den Vorteil, dass die Temperaturmessstelle nur durch eine sehr dünne Polymermembran 2c, beispielsweise mit einer Dicke von 25 µm, von der Kavität 15 getrennt ist und damit einen optimalen thermischen Kontakt zur Kavität 15 mit der Zieltemperatur hat. Zusätzlich ist durch das Fügen der Polymermembranen 2c, 2d untereinander bzw. mit dem Polymersubstrat 1c und dem Polymersubstratdeckel 10b die Dichtheit der beschriebenen Anordnung sichergestellt.

Versuche haben ergeben, dass derart hergestellte Thermoelemente zuverlässige Messwerte liefern, welche mit denen übereinstimmen, die durch konventionelle Thermoelemente erzielbar sind.

Obwohl die vorliegende Erfindung anhand bevorzugter Ausführungsbeispiele beschrieben wurde, ist sie darauf nicht beschränkt. Insbesondere sind die genannten Materialien und Topologien nur beispielhaft und nicht auf die erläuterten Beispiele beschränkt. Beispielsweise kann über der Struktur gemäß Fig. 1d) eine weitere Polymermembran und Metallfolie verschweißt und strukturiert werden. Für selbstklebende Metallfolien ist dies uneingeschränkt möglich. Wird eine Ausführungsform der Metallfolie verwendet, bei der ein Laserschweißvorgang zur Haftung zwischen Polymermembran und Metallfolie nötig ist, sollte beachtet werden, dass eine zusätzliche Leiterbahnebene nicht im Schatten (bezogen auf den Laserstrahl) einer zuvor erstellten Struktur angeordnet werden sollte. Für zwei Leiterbahnebenen können jedoch zwei Teilsysteme, wie in Abb. 1d) dargestellt, hergestellt werden, die dann mit einer zusätzlichen Polymermembran zwischen den Metallfolien verschweißt werden.

## Patentansprüche

1. Verfahren zum Metallisieren von Polymerschichtsystemen mit dem Schritten:
Bilden eines Schichtstapels (1, 2, 3; 1, 2 , 3'; 1, 2 , 3"; 1a, 2a, 3a; 1c, 2c, 3c, 3d) mit einem Polymersubstrat (1; 1a; 1c), einer Metallfolie (3; 3'; 3"; 3a; 3c, 3d) und einer dazwischenliegenden Polymermembran (2; 2a; 2c);
Bilden von einem oder mehreren Strukturbereichen (6; 6"'; 6""; 6a; 6c, 6d) in der Metallfolie (3; 3'; 3"; 3a; 3c, 3d) mittels eines ersten Laserbestrahlungsschrittes (L2; L2'); und
Entfernen der Metallfolie (3; 3'; 3"; 3a; 3c, 3d) aus einem zu dem oder den Strukturbereichen (6; 6"'; 6""; 6a; 6c, 6d) komplementären Bereich (6'),
wobei ein zweiter Laserbestrahlungsschritt (L1) durch eine von der Polymermembran (2; 2a, 2c) abgewandte Oberfläche (O1) des Polymersubstrats (1; 1a; 1c) durchgeführt wird, wodurch eine Schweißverbindung zwischen dem Polymersubstrat (1; 1a; 1c) und der Polymermembran (2; 2a; 2c) und eine Adhäsion zwischen der Polymermembran (2; 2a; 2c) und der Metallfolie (3; 3'; 3"; 3a; 3c, 3d) entsteht,
**dadurch gekennzeichnet, dass**
in der Metallfolie (3; 3'; 3"; 3a; 3c, 3d) zumindest bereichsweise Perforationen (4; 4') vorgesehen werden, in die die Polymermembran (2; 2a; 2c) beim zweiten Laserbestrahlungsschritt (L1) einfließt.

2. Verfahren nach Anspruch 1, wobei der Schichtstapel (1, 2, 3; 1, 2 , 3'; 1, 2 , 3"; 1a, 2a, 3a; 1c, 2c, 3c, 3d) beim zweiten Laserbehandlungsschritt (L1) in eine für Laserbestrahlung transparente Einspanneinrichtung (15a, 15b) eingespannt wird.

3. Verfahren nach Anspruch 1, oder 2, wobei beim ersten Laserbestrahlungsschritt (L2) ein Laserstrahl auf eine der Polymermembran abgewandte Oberseite (O2) der Metallfolie (3; 3'; 3"; 3a; 3c, 3d) gerichtet wird und entsprechende Schnittlinien (LL) in der Metallfolie (3; 3'; 3"; 3a; 3c, 3d) bildet.

4. Verfahren nach Anspruch 1, oder 2, wobei beim ersten Laserbestrahlungsschritt (L2) ein Laserstrahl auf eine der Polymermembran abgewandte Oberseite (O2) der Metallfolie (3; 3'; 3"; 3a; 3c, 3d) gerichtet wird und den zu dem oder den Strukturbereichen (6; 6"'; 6""; 6a; 6c, 6d) komplementären Bereich (6') abträgt und wobei der eine oder die mehreren Strukturbereiche (6; 6"'; 6""; 6a; 6c, 6d) auf der Polymermembran (2; 2a; 2c) verbleiben.

5. Verfahren nach Anspruch 1, wobei das Polymersubstrat (1; 1a; 1c) vor dem Bilden des Schichtstapels (1, 2, 3; 1, 2 , 3'; 1, 2 , 3"; 1a, 2a, 3a; 1c, 2c, 3c, 3d) mit der Polymermembran (2; 2a; 2c) verbunden wird.

6. Verfahren nach Anspruch 5, wobei ein zweiter Laserbestrahlungsschritt (L1) durch eine von der Polymermembran (2; 2a, 2c) abgewandte Oberfläche (O1) des Polymersubstrats (1; 1a; 1c) derart durchgeführt wird, dass eine Adhäsion zwischen der Polymermembran (2; 2a; 2c) und der Metallfolie (3; 3'; 3"; 3a; 3c, 3d) nur in dem einem oder den mehreren Strukturbereichen (6; 6"'; 6""; 6a; 6c, 6d) in der Metallfolie (3; 3'; 3"; 3a; 3c, 3d) entsteht.

7. Verfahren nach Anspruch 1, wobei die Perforationen (4') kegelartig ausgebildet werden und sich die Kegel von der Polymermembran (2; 2a; 2c) wegweisend aufweiten.

8. Verfahren zum Metallisieren von Polymerschichtsystemen mit dem Schritten:
Bilden eines Schichtstapels (1, 2, 3'; 1, 2, 3") mit einem Polymersubstrat (1), einer strukturierten, zumindest bereichsweise mit Perforationen (4; 4') versehenen Metallfolie (3'; 3") und einer dazwischenliegenden Polymermembran (2);
wobei nach dem Bilden des Schichtstapels (1, 2, 3'; 1, 2, 3") ein Laserbestrahlungsschritt (L1) durch eine von der Polymermembran (2) abgewandte Oberfläche (O1) des Polymersubstrats (1) durchgeführt wird, wodurch eine Schweißverbindung zwischen dem Polymersubstrat (1) und der Polymermembran (2) entsteht; und
wobei die Polymermembran (2) beim Laserbestrahlungsschritt (L1) in die Perforationen (4; 4') einfließt und Stege (2a; 2a') ausbildet.

9. Verfahren nach Anspruch 8, wobei die Perforationen (4') kegelartig ausgebildet werden und sich die Kegel von der Polymermembran (2) wegweisend aufweiten.

10. Polymerschichtsystem mit:
einem Schichtstapel (1, 2, 3'; 1, 2, 3") mit einem Polymersubstrat (1), einer strukturierten, zumindest bereichsweise mit Perforationen (4; 4') versehenen Metallfolie (3'; 3") mit einem oder mehreren Strukturbereichen (6'"; 6"") und einer dazwischenliegenden Polymermembran (2);
einer Schweißverbindung zwischen dem Polymersubstrat (1) und der Polymermembran (2); und
wobei sich die Polymermembran (2) in die Perforationen (4; 4') erstreckt.

11. Polymerschichtsystem nach Anspruch 10, wobei die Perforationen (4') kegelartig ausgebildet sind und sich die Kegel von der Polymermembran (2) wegweisend aufweiten.

12. Polymerschichtsystem mit:
einem Schichtstapel (1a, 2a, 3a) mit einem Polymersubstrat (1a), einer über dem Polymersubstrat (1a) angeordneten ersten Polymermembran (2a) und einer über der ersten Polymermembran (2a) angeordneten ersten Leiterbahn (6a) aus einer ersten Metallfolie (3a), hergestellt durch das Verfahren nach einem der Ansprüche 1 bis 7; und
einer über der ersten Leiterbahn (6a) angeordneten zweiten Polymermembran (2b) mit einem Kontaktloch (14a) und einer über der zweiten Polymermembran (2b) und dem Kontaktloch (14a) angeordneten zweiten Leitebahn (6b) aus einer zweiten Metallfolie (3b); und
einem Polymersubstratdeckel (10a) mit einem erhöhten Bereich (14), welcher derart auf der zweiten Leiterbahn (6b) und der zweiten Polymermembran (2b) angeordnet ist, dass die erste Leiterbahn (6a) und die zweite Leiterbahn (6b) über dem erhöhten Bereich (14) durch das Kontaktloch (14a) einen Kontakt (K) bilden.

13. Polymerschichtsystem mit:
einem Schichtstapel (1c, 2c, 3c, 3d) mit einem Polymersubstrat (1c), einer über dem Polymersubstrat (1c) angeordneten ersten Polymermembran (2c) und einer über der ersten Polymermembran (2c) angeordneten ersten Leiterbahn (6c) aus einer ersten Metallfolie (3c) und einer über der ersten Polymermembran (2c) angeordneten zweiten Leiterbahn (6d) aus einer zweiten Metallfolie (3d), wobei die erste und zweite Leiterbahn (6c, 6d) einen Thermoelementkontakt (16) bilden, hergestellt durch das Verfahren nach einem der Ansprüche 1 bis 7; und
einem Polymersubstratdeckel (10b), welcher eine Kavität (15) aufweist, mit einer über dem Polymersubstratdeckel (10b) und der Kavität (15) angeordneten zweiten Polymermembran (2d);
wobei der Polymersubstratdeckel (10b) derart auf dem Schichtstapel (1c, 2c, 3c, 3d) angeordnet ist, dass die Kavität (15) im Bereich des Thermoelementkontakts (16) angeordnet ist.

## Claims

1. Method for metallizing polymer layer systems comprises the steps of:
forming a layer stack (1, 2, 3; 1, 2, 3'; 1, 2, 3"; 1a, 2a, 3a; 1c, 2c, 3c, 3d) with a polymer substrate (1; 1a; 1c), a metal film (3; 3'; 3"; 3a; 3c, 3d) and an interposed polymer membrane (2; 2a; 2c);
forming one or more structure regions (6; 6'''; 6""; 6a; 6c, 6d) in the metal film (3; 3'; 3"; 3a; 3c, 3d) by means of a first laser irradiation step (L2; L2'); and
removing the metal film (3; 3'; 3"; 3a; 3c, 3d) from a region (6') which is complementary to the structure region or regions (6; 6"'; 6'"'; 6a; 6c, 6d),
wherein a second laser irradiation step (L1) is performed through a surface (O1) of the polymer substrate (1; 1a; 1c) facing away from the polymer membrane (2; 2a, 2c), as a result of which a welded join is produced between the polymer substrate (1; 1a; 1c) and the polymer membrane (2; 2a, 2c) and an adhesion is produced between the polymer membrane (2; 2a, 2c) and the metal film (3; 3'; 3"; 3a; 3c, 3d),
**characterized in that**
perforations (4; 4') into which the polymer membrane (2; 2a; 2c) flows during the second laser irradiation step (L1) are provided at least in certain regions in the metal film (3; 3'; 3"; 3a; 3c, 3d).

2. Method according to Claim 1, wherein, during the second laser irradiation step (L1), the layer stack (1, 2, 3; 1, 2, 3'; 1, 2, 3"; 1a, 2a, 3a; 1c, 2c, 3c, 3d) is clamped into a clamping device (15a, 15b) transparent to laser irradiation.

3. Method according to Claim 1 or 2, wherein, during the first laser irradiation step (L2), a laser beam is directed onto an upper side (O2) of the metal film (3; 3'; 3"; 3a; 3c, 3d) facing away from the polymer membrane and forms corresponding cut lines (LL) in the metal film (3; 3'; 3"; 3a; 3c, 3d).

4. Method according to Claim 1 or 2, wherein, during the first laser irradiation step (L2), a laser beam is directed onto an upper side (O2) of the metal film (3; 3'; 3"; 3a; 3c, 3d) facing away from the polymer membrane and removes the region (6') which is complementary to the structure region or regions (6; 6"'; 6""; 6a; 6c, 6d) and wherein the one or more structure regions (6; 6"'; 6'"'; 6a; 6c, 6d) remain on the polymer membrane (2; 2a; 2c) .

5. Method according to Claim 1, wherein the polymer substrate (1; 1a; 1c) is joined to the polymer membrane (2; 2a; 2c) before the forming of the layer stack (1, 2, 3; 1, 2, 3'; 1, 2, 3''; 1a, 2a, 3a; 1c, 2c, 3c, 3d).

6. Method according to Claim 5, wherein a second laser irradiation step (L1) is carried out through a surface (O1) of the polymer substrate (1; 1a; 1c) facing away from the polymer membrane (2; 2a, 2c) in such a way that an adhesion is produced between the polymer membrane (2; 2a; 2c) and the metal film (3; 3'; 3"; 3a; 3c, 3d) only in the one or more structure regions (6; 6"'; 6""; 6a; 6c, 6d) in the metal film (3; 3'; 3"; 3a; 3c, 3d).

7. Method according to Claim 1, wherein the perforations (4') are formed conically and the cones widen out away from the polymer membrane (2; 2a; 2c).

8. Method for metallizing polymer layer systems comprising the steps of:
forming a layer stack (1, 2, 3'; 1, 2, 3'') with a polymer substrate (1), a structured metal film (3'; 3''), provided at least in certain regions with perforations (4; 4''), and an interposed polymer membrane (2);
wherein, after the forming of the layer stack (1, 2, 3'; 1, 2, 3''), a laser irradiation step (L1) is performed through a surface (O1) of the polymer substrate (1) facing away from the polymer membrane (2), as a result of which a welded join is produced between the polymer substrate (1) and the polymer membrane (2); and
wherein, during the laser irradiation step (L1), the polymer membrane (2) flows into the perforations (4; 4') and forms webs (2a; 2a').

9. Method according to Claim 8, wherein the perforations (4') are formed conically and the cones widen out away from the polymer membrane (2).

10. Polymer layer system with:
a layer stack (1, 2, 3'; 1, 2, 3") with a polymer substrate (1), a structured metal film (3'; 3''), provided at least in certain regions with perforations (4; 4') and with one or more structure regions (6'''; 6""), and an interposed polymer membrane (2);
a welded join between the polymer substrate (1) and the polymer membrane (2); and
wherein the polymer membrane (2) extends into the perforations (4; 4').

11. Polymer layer system according to Claim 10, wherein the perforations (4') are conically formed and the cones widen out away from the polymer membrane (2).

12. Polymer layer system with:
a layer stack (1a, 2a, 3a) with a polymer substrate (1a), a first polymer membrane (2a), arranged over the polymer substrate (1a), and a first conductor track (6a), arranged over the first polymer membrane (2a), comprising a first metal film (3a), produced by the method according to one of Claims 1 to 7; and
a second polymer membrane (2b), arranged over the first conductor track (6a), with a contact hole (14a) and a second conductor track (6b), arranged over the second membrane (2b) and the contact hole (14a), comprising a second metal film (3b); and
a polymer substrate cover (10a) with an elevated region (14) which is arranged on the second conductor track (6b) and the second polymer membrane (2b) in such a way that the first conductor track (6a) and the second conductor track (6b) form a contact (K) over the elevated region (14) through the contact hole (14a).

13. Polymer layer system with:
a layer stack (1c, 2c, 3c, 3d) with a polymer substrate (1c), a first polymer membrane (2c), arranged over the polymer substrate (1c), and a first conductor track (6c), arranged over the first polymer membrane (2c), comprising a first metal film (3c), and a second conductor track (6d), arranged over the first polymer membrane (2c), comprising a second metal film (3d), wherein the first and second conductor tracks (6c, 6d) form a thermocouple contact (16), produced by the method according to one of Claims 1 to 7; and
a polymer substrate cover (10b), which has a cavity (15), with a second polymer membrane (2d), arranged over the polymer substrate cover (10b) and the cavity (15);
wherein the polymer substrate cover (10b) is arranged on the layer stack (1c, 2c, 3c, 3d) in such a way that the cavity (15) is arranged in the region of the thermocouple contact (16).

## Revendications

1. Procédé de métallisation de systèmes de couches polymères, comprenant les étapes suivantes:
former un empilement de couches (1, 2, 3; 1, 2, 3'; 1, 2, 3"; 1a, 2a, 3a; 1c, 2c, 3c, 3d) avec un substrat polymère (1; 1a; 1c), une feuille métallique (3; 3'; 3"; 3a; 3c, 3d) et une membrane polymère (2; 2a; 2c) disposée entre ceux-ci;
former une ou plusieurs zone(s) de structure (6; 6"'; 6""; 6a; 6c, 6d) dans la feuille métallique (3; 3'; 3"; 3a; 3c, 3d) au moyen d'une première étape d'exposition à un rayonnement laser (L2; L2'); et enlever la feuille métallique (3; 3'; 3"; 3a; 3c, 3d) hors d'une zone (6') complémentaire à la ou aux zone(s) de structure (6; 6'''; 6''''; 6a; 6c, 6d),
dans lequel on exécute une deuxième étape d'exposition à un rayonnement laser (L1) à travers une surface (O1) du substrat polymère (1; 1a; 1c) située à l'opposé de la membrane polymère (2; 2a; 2c), ce qui crée un assemblage soudé entre le substrat polymère (1; 1a; 1c) et la membrane polymère (2; 2a; 2c) et une adhérence entre la membrane polymère (2; 2a; 2c) et la feuille métallique (3; 3'; 3"; 3a, 3c, 3d),
**caractérisé en ce qu'**il est prévu dans la feuille métallique (3; 3'; 3"; 3a; 3c, 3d) au moins localement des perforations (4; 4'), dans lesquelles la membrane polymère (2; 2a; 2c) s'écoule lors de la deuxième étape d'exposition à un rayonnement laser (L1).

2. Procédé selon la revendication 1, dans lequel on serre l'empilement de couches (1, 2, 3; 1, 2, 3'; 1, 2, 3"; 1a, 2a, 3a; 1c, 2c, 3c, 3d) dans un dispositif de serrage (15a, 15b) transparent pour le rayonnement laser lors de la deuxième étape d'exposition à un rayonnement laser (L1).

3. Procédé selon la revendication 1 ou 2, dans lequel lors de la première étape d'exposition à un rayonnement laser (L2) on dirige un faisceau laser sur un côté supérieur (O2) de la feuille métallique (3; 3', 3"; 3a; 3c, 3d) situé à l'opposé de la membrane polymère et il forme des lignes de coupe correspondantes (LL) dans la feuille métallique (3; 3'; 3"; 3a; 3c, 3d).

4. Procédé selon la revendication 1 ou 2, dans lequel lors de la première étape d'exposition à un rayonnement laser (L2) on dirige un faisceau laser sur un côté supérieur (O2) de la feuille métallique (3; 3'; 3"; 3a; 3c, 3d) situé à l'opposé de la membrane polymère et il enlève la zone (6') complémentaire à la ou aux zone (s) de structure (6; 6"'; 6''''; 6a; 6c, 6d) et dans lequel ladite une ou lesdites plusieurs zone(s) de structure (6; 6"'; 6''''; 6a; 6c, 6c) reste (nt) sur la membrane polymère (2; 2a; 2c).

5. Procédé selon la revendication 1, dans lequel on assemble le substrat polymère (1; 1a; 1c) à la membrane polymère (2; 2a; 2c) avant la formation de l'empilement de couches (1, 2, 3; 1, 2, 3'; 1, 2, 3"; 1a, 2a, 3a; 1c, 2c, 3c, 3d).

6. Procédé selon la revendication 5, dans lequel on exécute une deuxième étape d'exposition à un rayonnement laser (L1) à travers une surface (O1) du substrat polymère (1; 1a; 1c) située à l'opposé de la membrane polymère (2; 2a; 2c), de telle manière qu'il se crée une adhérence entre la membrane polymère (2; 2a; 2c) et la feuille métallique (3; 3'; 3"; 3a; 3c, 3d) uniquement dans ladite une ou lesdites plusieurs zone(s) de structure (6; 6'''; 6""; 6a; 6c, 6d) dans la feuille métallique (3; 3'; 3"; 3a; 3c, 3d).

7. Procédé selon la revendication 1, dans lequel on forme les perforations (4') en forme de cône et les cônes s'élargissent en s'écartant de la membrane polymère (2; 2a; 2c).

8. Procédé de métallisation de systèmes de couches polymères comprenant les étapes suivantes:
former un empilement de couches (1, 2, 3'; 1, 2, 3") avec un substrat polymère (1), une feuille métallique (3'; 3'') structurée, au moins localement dotée de perforations (4; 4') et une membrane polymère (2) disposée entre ceux-ci;
dans lequel après la formation de l'empilement de couches (1, 2, 3'; 1, 2, 3") on exécute une étape d'exposition à un rayonnement laser (L1) à travers une surface (O1) du substrat polymère (1) située à l'opposé de la membrane polymère (2), ce qui crée un assemblage soudé entre le substrat polymère (1) et la membrane polymère (2); et
dans lequel la membrane polymère (2) s'écoule dans les perforations (4; 4') lors de l'étape d'exposition à un rayonnement laser (L1) et forme des nervures (2a; 2a').

9. Procédé selon la revendication 8, dans lequel on réalise les perforations (4') en forme de cône et les cônes s'élargissent en s'écartant de la membrane polymère (2) .

10. Système de couches polymères avec:
un empilement de couches (1, 2, 3'; 1, 2, 3") avec un substrat polymère (1), une feuille métallique (3'; 3") structurée, au moins localement dotée de perforations (4; 4') avec une ou plusieurs zone(s) de structure (6'''; 6'''') et une membrane polymère (2) disposée entre ceux-ci;
un assemblage soudé entre le substrat polymère (1) et la membrane polymère (2); et
dans lequel la membrane polymère (2) s'étend dans les perforations (4; 4').

11. Système de couches polymères selon la revendication 10, dans lequel les perforations (4') sont réalisées en forme de cône et s'élargissent en s'écartant de la membrane polymère (2).

12. Système de couches polymères, avec:
un empilement de couches (1a, 2a, 3a) avec un substrat polymère (1a), une première membrane polymère (2a) disposée au-dessus du substrat polymère (1a), et une première piste conductrice (6a) en une première feuille métallique (3a), disposée au-dessus de la première membrane polymère (2a) et fabriquée par le procédé selon l'une quelconque des revendications 1 à 7; et
une seconde membrane polymère (2b) disposée au-dessus de la première piste conductrice (6a) avec un trou de contact (14a) et une seconde piste conductrice (6b) en une seconde feuille métallique (3b), disposée au-dessus de la seconde membrane polymère (2b) et du trou de contact (14a); et
un couvercle de substrat polymère (10a) avec une région surélevée (14), qui est disposée au-dessus de la seconde piste conductrice (6b) et de la seconde membrane polymère (2b), de telle manière que la première piste conductrice (6a) et la seconde piste conductrice (6b) forment un contact (K) à travers le trou de contact (14a) au-dessus de la région surélevée (14).

13. Système de couches polymères, avec:
un empilement de couches (1c, 2c, 3c, 3d) avec un substrat polymère (1c), une première membrane polymère (2c) disposée au-dessus du substrat polymère (1c), et une première piste conductrice (6c) en une première feuille métallique (3c), disposée au-dessus de la première membrane polymère (2c) et une seconde piste conductrice (6d) en une seconde feuille métallique (3d), disposée au-dessus de la première membrane polymère (2c), dans lequel la première et la seconde pistes conductrices (6c, 6d) forment un contact de thermoélément (16), fabriqué par le procédé selon l'une quelconque des revendications 1 à 7; et
un couvercle de substrat polymère (10b), qui présente une cavité (15), avec une seconde membrane polymère (2d) disposée au-dessus du couvercle de substrat polymère (10b) et de la cavité (15);
dans lequel le couvercle de substrat polymère (10b) est disposé sur l'empilement de couches (1c, 2c, 3c, 3d), de telle manière que la cavité (15) soit disposée dans la région du contact de thermoélément (16).
